(19) Europäisches Patentamt

European Patent Office

Office européen des brevets

(11) Veröffentlichungsnummer: **0 326 899**
**A2**

(12) **EUROPÄISCHE PATENTANMELDUNG**

(21) Anmeldenummer: 89101133.0

(22) Anmeldetag: 23.01.89

(51) Int. Cl.⁴: **H03L 7/14**

(30) Priorität: 29.01.88 DE 3802687

(43) Veröffentlichungstag der Anmeldung:
09.08.89 Patentblatt 89/32

(84) Benannte Vertragsstaaten:
AT BE CH DE ES FR GB IT LI NL SE

(71) Anmelder: **Siemens Aktiengesellschaft Berlin
und München**
**Wittelsbacherplatz 2**
**D-8000 München 2(DE)**

(72) Erfinder: **Busch, Peter, Dipl.-Ing.**
**Thommstrasse 24**
**D-8900 Augsburg(DE)**
Erfinder: **Sterzik, Willi, Dipl.-Ing.**
**Karlsbader Strasse 28**
**D-8900 Augsburg(DE)**

(54) **Schaltungsanordnung zur Bildung eines digitalen Taktsignals.**

㊥ Zur Bildung eines digitalen Taktsignals (7), das in Frequenz und Phase mit einer elektrischen Eingangswechselgröße (51) bei deren Anwesenheit übereinstimmt und während deren Abwesenheit weiterhin zur Verfügung steht, ist eine Phasenregelschleife vorgesehen. Diese setzt sich zusammen aus einem in Abhängigkeit einer Abstimmgröße seine Frequenz verändernden Taktgenerator (4) für das digitale Taktsignal (7), einem Phasenkomparator (1) zur Ermittlung jeweiliger Differenzwerte zwischen der elektrischen Eingangswechselgröße (51) und dem digitalen Taktsignal (7) und einem Speicherelement (3) für die von den Differenzwerten korrigierbare Abstimmgröße. Eine Überwachungseinrichtung (2) prüft die jeweiligen Differenzwerte auf Über- bzw. Unterschreitung vorgegebener Grenzwerte. In einem Prüfzustand werden nur die innerhalb der Grenzwerte liegenden Differenzwerte an das Speicherelement (3) weitergeleitet.

FIG 1

EP 0 326 899 A2

## Schaltungsanordnung zur Bildung eines digitalen Taktsignals

Die Erfindung betrifft eine Schaltungsanordnung zur Bildung eines digitalen Taktsignals nach dem Oberbegriff des Patentanspruchs 1.

An die Zuverlässigkeit technischer Einrichtungen werden immer höhere Anforderungen gestellt, die letztendlich auch den Wunsch nach einer gewissen Autonomiefähigkeit mit einschließen. In der Praxis kann dies für eine Einrichtung bedeuten, wenigstens noch für kurze Zeit ihre Funktionen aufrechtzuerhalten, auch wenn die Zufuhr wesentlicher Eingangsgrößen unterbrochen worden ist.

Die wohl wichtigste Eingangsgröße stellt im allgemeinen die Energiezufuhr dar, deren Ausfall von einer Einrichtung durch Zugriff auf interne Energiespeicher überbrückt werden muß.

Im Bereich der Elektrotechnik z.B. werden als interne Energiespeicher Batterien vorgesehen, auf die bei Ausfall der öffentlichen Netzversorgung umgeschaltet wird.

Der ersatzweise Gebrauch interner Energiespeicher gestaltet sich relativ unproblematisch, solange eine betreffende Einrichtung nur eine statische Form von Energie benötigt. Sobald aber eine Energieform mit einem zeitabhängigen Faktor versehen ist, und die mit diesem gekoppelte Information von einer Einrichtung ausgewertet wird, tritt, wenn nicht besondere Maßnahmen getroffen werden, mit einem Ausfall der Energiezufuhr auch ein Informationsverlust ein.

Die Zufuhr elektrischer Energie in öffentlichen Netzversorgungen in Form von Wechsel- oder Drehstrom ist mit einem derartigen zeitabhängigen Faktor behaftet, der sich in einer Frequenz- und Phaseninformation verbirgt. Um aus einer Batterie, deren elektrische Energieform statisch ist, Wechsel- oder Drehstrom zu gewinnen, muß ein Wechselrichter vorgesehen werden. Zudem ist dem Wechselrichter die Frequenz- und Phaseninformation vorzugeben, die mit derjenigen des Wechsel- bzw. Drehstroms aus der Netzversorgung übereinstimmt, damit der vom Wechselrichter gebildete Strom mit demjenigen aus der Netzversorgung ohne Phasensprung und Frequenzänderung gewissermaßen nahtlos ineinander übergehen kann.

Die dem Wechselrichter zu diesem Zweck vorzugebende Frequenz-und Phaseninformation wird in der Regel einer Phasenregelschleife entnommen, die sich im wesentlichen aus einem variablen Frequenzgenerator und einem Phasenkomparator, z.B. Fairchild F4046 zusammensetzt.

Solang die Netzversorgung zur Verfügung steht, wird die Frequenz des variablen Frequenzgenerators vom Phasenkomparator überwacht und bei Bedarf anhand von Differenzwerten sofort korrigiert, so daß die Frequenz- und Phaseninformation der Phasenregelschleife mit derjenigen der Netzversorgung übereinstimmt. Eine Beschränkung auf eine bestimmte Netzfrequenz ist somit nicht gegeben.

Bei Ausfall der Netzversorgung bleibt die eingestellte Information erhalten und kann dem Wechselrichter, z.B. in Form eines digitalen Taktsignals zugeführt werden.

Häufig können aber in der Netzversorgung, insbesondere unmittelbar vor Ausfällen, starke Störungen auftreten, die den Phasenkomparator zu ungerechtfertigten Korrekturen des variablen Frequenzgenerators veranlassen. Diese führen dann dazu, daß im Falle eines folgenden Netzversorgungsausfalls dem Wechselrichter ein Taktsignal mit falscher Frequenz oder Phasenlage zugeleitet wird.

Aufgabe dieser Erfindung ist es deshalb, eine Schaltungsanordnung nach dem Oberbegriff des Patentanspruchs 1 so zu verbessern, daß extreme Differenzwerte keine Korrektur bewirken können.

Gelöst wird die Aufgabe erfindungsgemäß durch die im kennzeichnenden Teil des Patentanspruchs 1 angegebenen Merkmale.

Da die Frequenz der elektrischen Eingangswechselgröße als äusserst konstant vorausgesetzt werden kann, und der Phasenkomparator jeweils pro Taktperiode einen Differenzwert ermittelt, sind die Differenzwerte ihrem Betrag nach im Normalfall, d.h. im eingeschwungenen Zustand der Phasenregelschleife sehr klein. Ein größerer Differenzwert kann nur dann auftreten, wenn sich Phase oder Frequenz der elektrischen Eingangswechselgröße verändert. Da dies aber nach Voraussetzung nicht der Fall sein kann, muß bei größeren Differenzwerten mit Sicherheit eine Störung der Eingangswechselgröße vorliegen, so daß die während einer Störung ermittelten Differenzwerte nicht für eine Korrektur in der Phasenregelschleife verwendet werden dürfen. Dazu ist die Überwachungseinrichtung vorgesehen, die Störungen der elektrischen Eingangswechselgröße am Betrag der Differenzwerte erkennen kann und jeden vom Phasenkomparator ermittelten Differenzwert als erstes prüft und dann in Abhängigkeit vom Prüfergebnis zur Korrektur weitergibt oder gänzlich verwirft. Auf diese Weise läßt sich eine hohe Störsicherheit der Phasenregelschleife realisieren, die deshalb auch trotz vorausgegangener Störungen bei einem Ausfall der elektrischen Eingangswechselgröße deren Frequenz und Phaseninformation weiterhin mit hoher Genauigkeit zur Verfügung stellen kann.

Vorteilhafte Ausgestaltungen der Erfindung sind in den Unteransprüchen angegeben.

Damit es durch die Überwachungseinrichtung nicht zu einem gänzlichen Abriß des Regelprozesses kommen kann, ist ein Einschwingzustand vorgesehen, der ein Weiterleiten der Differenzwerte unter Umgehung der Überwachungseinrichtung ermöglicht. Ein bidirektionaler Digitalzähler, z.B. Fairchild F4516, eignet sich in idealer Weise für eine schaltungstechnische Realisierung der Überwachungseinrichtung, da er mit nur geringer zusätzlicher Beschaltung die wesentlichen Funktionen der Überwachungseinrichtung erfüllen kann. Die Länge eines jeweiligen, vom Phasenkomparator abgegebenen Phasendifferenzimpulses wird in Vielfachen der Taktperiode eines Taktgebers angegeben und in Form eines Zählerstandes gespeichert. Dieser Zählerstand steht damit in linearem Zusammenhang zur Impulslänge, die somit in einfacher Weise auf Bereichsüberschreitungen überprüft werden kann, und die sich durch Zurückzählen des Digitalzählers bis zu seinem Ausgangszustand wieder äußerst exakt reproduzieren läßt.

Ein Ausführungsbeispiel der Erfindung wird im folgenden anhand der Zeichnung näher erläutert.

Dabei zeigen

FIG 1 ein Blockschaltbild einer erfindungsgemäßen Anordnung für eine Phasenregelschleife mit Überwachungseinrichtung

FIG 2 eine Schaltungsanordnung zur Realisierung der Überwachungseinrichtung gemäß FIG 1.

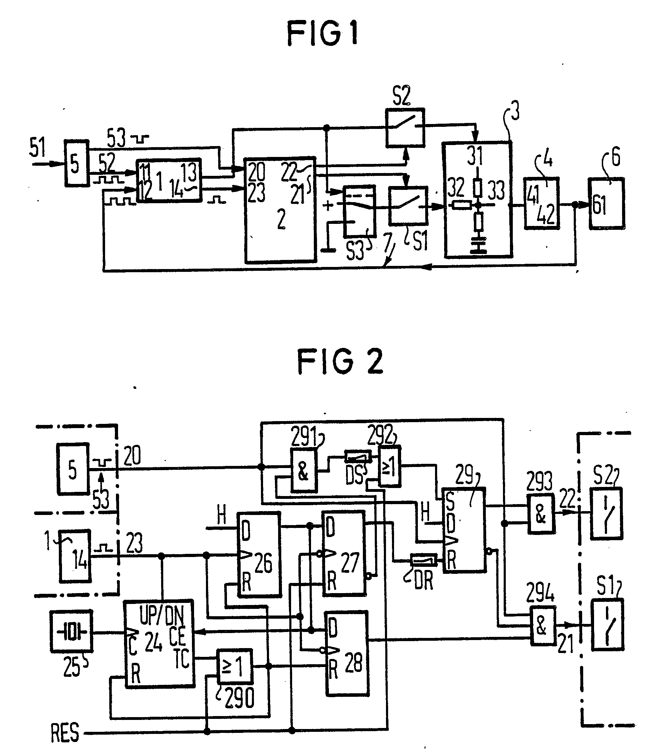

Die FIG 1 zeigt jeweils in schematischer Darstellung wesentliche Komponenten und deren gegenseitige Zuordnung in einer erfindungsgemäßen Schaltungsanordnung zum Betreiben eines Wechselrichters bei Ausfall einer Netzwechselspannung.

Die wesentlichen Komponenten, aus denen sich die Schaltung zusammensetzt, sind ein Phasenkomparator 1, eine Überwachungseinrichtung 2, ein Speicherelement 3 und ein variabler Frequenzgenerator 4, die in angegebener Reihenfolge in Form einer Schleife miteinander verbunden sind. Zudem ist zur Erzeugung eines digitalen Eingangstaktsignales 52 und eines digitalen Netzausfallsignales 53 aus einer elektrischen Eingangswechselgröße 51 ein Sensorelement 5 vorgesehen, das dem Phasenkomparator 1 und der Überwachungseinrichtung 2 vorgeschaltet ist und im wesentlichen die Funktionen eines Schmitt-triggers erfüllt.

Das digitale Eingangstaktsignal 52 ist einem ersten Vergleichereingang ll des Phasenkomparators 1 und das digitale Netzausfallsignal 53 einem Kontrolleingang 20 der Überwachungseinrichtung 2 zugeführt. Der Phasenkomparator 1 ist mit einem Binärwertausgang 14 an einen Differenzwerteingang 23 der Überwachungseinrichtung 2 angeschlossen, die mit zwei Schaltausgängen 21, 22 versehen ist. Der erste Schaltausgang 21 ist an einen Aktivierungseingang eines ersten Schaltelementes S1 und der zweite Schaltausgang 22 an einen Aktivierungseingang eines zweiten Schaltelementes S2 angeschlossen.

Das zweite Schaltelement S2 verbindet einen Analogwertausgang 13 des Phasenkomparators 1 mit einem ersten Korrektureingang 31 des Speicherelementes 3. Dem ersten Schaltelement S1 ist ein Umschaltelement 53 vorgeschaltet, das mit seinen beiden Eingängen an unterschiedlichen Spannungspotentialen liegt. Ausgangsseitig ist das erste Schaltelement S1 mit einem zweiten Korrektureingang 32 des Speicherelementes 3 verbunden. Weiterhin ist das Umschaltelement S3 mit seinem Umschalteingang an den Analogwertausgang 13 des Phasenkomparators 1 angeschlossen. Das Speicherelement 3 ist an seinem Potentialausgang 33 mit dem Abstimmeingang 41 des variablen Frequenzgenerators 4 verbunden, dessen Generatorausgang 42 an den zweiten Vergleichereingang l2 des Phasenkomparators 1 und an den Impulseingang 61 eines Wechselrichters 6 angeschlossen ist.

Ein am Generatorausgang 42 des variablen Frequenzgenerators 4 zur Verfügung stehendes digitales Taktsignal 7 ist in seiner Frequenz proportional abhängig von der Höhe eines am Potentialausgang 33 des Speicherelements 3 anliegenden Abstimmpotentials. Dieses Speicherelement 3 läßt sich, da der variable Frequenzgenerator 4 eingangsseitig sehr hochohmig ist, als Tiefpaß mit einer Serienschaltung aus einem Widerstand und einem Speicherkondensator realisieren, wobei die Kondensatorspannung im wesentlichen das Abstimmpotential bildet. Um das Abstimmpotential und damit die Frequenz des digitalen Taktsignals 7 zu korrigieren, sind die Korrektureingänge 31, 32 vorhanden, über die dem Speicherkondensator elektrische Energie zugeführt oder entzogen werden kann, je nachdem, ob eine an einen Korrektureingang 31, 32 geführte Spannung über- oder unterhalb der Kondensatorspannung liegt. Die Menge der zugeführten oder entzogenen Energie ist wiederum vom zugeführten oder entnommenen Strom und dessen Dauer abhängig.

An seinem Analogwertausgang 13 bietet der Phasenkomparator 1 nun digitale Phasendifferenzimpulse an, deren Länge jeweils dem zeitlichen Abstand zwischen einem Pegelwechsel bei dem Eingangstaktsignal 52 und einem gleichsinnigen Pegelwechsel des digitalen Taktsignals 7 entsprechen. Ob ein Phasendifferenzimpuls einen H- oder L-Pegel einnimmt, ist davon abhängig, ob der bewertete Pegelwechsel des digitalen Taktsignals 7 später bzw. früher als der des digitalen Eingangstaktsignals 52 auftrat. Zwischen den Phasendifferenzimpulsen ist der Analogwertausgang 13 freigeschaltet.

Dagegen stellt der Binärwertausgang 14 des

Phasenkomparators I nur Phasendifferenzimpulse in Form digitaler H-Pegel zur Verfügung, wobei zwischen einzelnen Phasendifferenzimpulsen der Binärwertausgang 14 mit einem digitalen L-Pegel beaufschlagt wird.

Für die zur Überprüfung der Länge von Phasendifferenzimpulsen vorgesehene Überwachungseinrichtung 2 ist diese am Binärwertausgang 14 des Phasenkomparators 1 anliegende Information ausreichend. Die Überwachungseinrichtung 2, auf deren Funktion in Verbindung mit FIG 2 noch näher eingegangen wird, mißt im Prinzip die Dauer eines jeweiligen Phasendifferenzimpulses und aktiviert dann, falls die gemessene Dauer einen eingestellten Wert nicht überschritten hat, für die gleiche Dauer das erste Schaltelement S1, über dieses dann abhängig von der Stellung des Umschaltelementes S3 der zweite Korrektureingang 32 des Speicherelementes 3 mit einem positiven Spannungspotential oder einem Massepotential beaufschlagt wird. Die Stellung des Umschaltelementes S3 ist jeweils von dem zuletzt am Analogwertausgang 13 des Phasenkomparators 1 angelegten digitalen Pegel abhängig.

Solange nun die Netzwechselspannung 51 zur Verfügung steht, erfolgt ein ständiges Korrigieren des Abstimmpotentials, so daß das digitale Taktsignal 7 in Frequenz und Phase möglichst genau mit der Netzwechselspannung 51 übereinstimmt.

Bei einem Ausfall der Netzwechselspannung 51, die das Sensorelement 5 erkennt und signalisiert, wird sofort der Wechselrichter 6 aktiviert und die Überwachungseinrichtung 2 sperrt ihre Schaltausgänge 21, 22, so daß keine Korrektur des Abstimmpotentials mehr möglich ist.

Bei einer Wiederkehr der Netzwechselspannung 51 wird dies vom Sensorelement 5 auch der Überwachungseinrichtung 2 gemeldet. Eine Deaktivierung des Wechselrichters 6 darf aber nicht sofort erfolgen, da sich Frequenz und Phase des digitalen Taktsignals 7 gegenüber der Netzwechselspannung 51 verschoben haben könnte und ein Phasensprung beim Umschalten von der vom Wechselrichter 6 erzeugten Wechselspannung auf die Netzwechselspannung 51 vermieden werden sollte. Deshalb muß das digitale Taktsignal 7 wieder in Frequenz und Phase mit der Netzwechselspannung 51 in Übereinstimmung gebracht werden, bevor eine derartige Umschaltung durchgeführt wird.

Bei einer nach Wiederkehr der Netzwechselspannung 51 erforderlichen Korrektur des Abstimmpotentials muß mit langen Phasendifferenzimpulsen gerechnet werden, die natürlich von der Überwachungseinrichtung 2 in diesem Falle nicht verworfen werden dürfen. Solange nun nach Wiederkehr der Netzwechselspannung 51 die Phasendifferenzimpulse, die in der Überwachungseinrichtung 2 eingestellte Dauer überschreiten, wird das zweite Schaltelement S2 aktiviert, das im Prinzip die Überwachungseinrichtung 2 überbrückt. Haben sich die Phasendifferenzimpulse wieder auf eine geringe Impulsdauer reduziert, übernimmt die Überwachungseinrichtung 2 wieder ihre volle Funktion. Eine Umschaltung auf die Netzwechselspannung ist jetzt ohne Phasensprung möglich.

In FIG 2 ist ein Stromlaufplan für eine Realisierung der in FIG 1 beschriebenen Überwachungseinrichtung dargestellt. Im wesentlichen ist ein bidirektionaler Digitalzähler 24 in Verbindung mit einem digitalen Schaltwerk aus Kippstufen und Verknüpfungselementen zu erkennen. Weiter sind der Kontrolleingang 20 und der Differenzwerteingang 23 sowie der erste und der zweite Schaltausgang 21, 22 gezeigt.

Der als vierstelliger Binärzähler ausgeführte Digitalzähler 24, dessen Takteingang C von einem Taktgeber 25 beaufschlagt wird, ist mit seinem Richtungskontrolleingang UP/DN an den Differenzwerteingang 23 angeschlossen, mit dem auch der jeweilige Takteingang einer ersten und zweiten Steuerkippstufe 26, 27 und der einer ersten Schaltkippstufe 28 verbunden ist. Der Takteingang der zweiten Steuerkippstufe 27 und derjenige der ersten Schaltkippstufe 28 sind invertierend ausgeführt.

Die zweite Steuerkippstufe 27 und die erste Schaltkippstufe 28 sind mit ihren jeweiligen D-Eingängen an den Ausgang der ersten Steuerkippstufe 26 angeschlossen, der auch auf einen Freigabe-Eingang CE des Digitalzählers 24 geführt ist. Am D-Eingang der ersten Steuerkippstufe 26 liegt ein digitaler H-Pegel an.

Ein Überlauf- oder Unterlaufsignal, das der Digitalzähler 24 bei unmittelbaren Zählerstandsübergängen von 1111 nach 0000 (Zählerüberlauf) bzw. von 0000 nach 1111 (Zählerunterlauf) erzeugt und über ein logisches ODER-Glied miteinander verknüpft an seinem Zählerausgang TC zur Verfügung stellt, wird von einem ersten ODER-Glied 290 mit einem Schaltungsrücksetzsignal RES verknüpft und dem Rücksetzeingang R der ersten Steuerkippstufe 26, dem der ersten Schaltkippstufe 28 und dem des Digitalzählers 24 zugeführt. Der Rücksetzeingang R der zweiten Steuerkippstufe 27 wird von dem Schaltungsrücksetzsignal RES unmittelbar beaufschlagt.

Der zweiten Steuerkippstufe 27 ist ausgangsseitig eine zweite Schaltkippstufe 29 zugeordnet, deren Takteingang mit dem das Netzausfallsignal 53 zuführenden Kontrolleingang 20 verbunden ist. Dieses Netzausfallsignal 53 ist zudem über ein UND-Glied 291, das eingangsseitig noch mit dem invertierenden Ausgang der zweiten Steuerkippstufe 27 verbunden ist, auf ein Setzverzögerungsglied DS geführt, das mit seinem Ausgang an einen Eingang eines zweiten ODER-Gliedes 292 angeschlossen ist. Auf einen zweiten Eingang des ausgangsseitig mit dem Setzeingang S der zweiten Schaltkippstufe 29 verbundenen zweiten ODER-Gliedes 292, ist das Schaltungsrücksetzsignal RES geführt. Am D-Eingang der zweiten Schaltkippstufe 29 liegt ein H-Pegel an, und ihr Rücksetzeingang R ist über ein Rücksetzverzögerungsglied RS mit dem Ausgang der zweiten Steuerkippstufe 27 verbunden.

Das Setz- und Rücksetzverzögerungsglied DS, RS setzt sich jeweils aus einer Parallelschaltung eines Widerstandes und einer Diode mit Vorwiderstand zusammen, wobei ein anodenseitiger Ausgang vorgesehen ist, der zudem über einen Kondensator am Massepotential liegt.

Eine erste und eine zweite Torschaltung 294, 293, jeweils in Form eines UND-Gliedes ausgeführt, bilden mit ihrem jeweiligen Ausgang den ersten bzw. den zweiten Schaltausgang 21, 22. Die erste Torschaltung 294 ist eingangsseitig mit dem Ausgang der ersten Schaltkippstufe 28, dem invertierenden Ausgang der zweiten Schaltkippstufe 29 und dem Kontrolleingang 20 verbunden. Die zweite Torschaltung 293 ist nur an den Ausgang der zweiten Schaltkippstufe 29 und an den Kontrolleingang 20 angeschlossen.

Wie jedes digitale Schaltwerk, so hat auch die gezeigte Schaltungsanordnung einen mit Hilfe eines Schaltungsrücksetzsignals RES einstellbaren Grundzustand, den sie vor Aufnahme ihrer Funktion einnimmt.

Da nun das digitale Taktsignal 7 des variablen Frequenzgenerators 4 nach dem Einschalten der gesamten Einrichtung in frequenz und Phase voraussichtlich stark von der Netzwechselspannung 51 abweicht, dürfen die während einer Einschwingphase zu erwartenden Phasendifferenzimpulse nicht von der Überwachungseinrichtung 2 verworfen werden, sondern müssen ungehindert dem Speicherelement 3 zugeführt werden.

Damit eine möglichst schnelle Anpassung des digitalen Taktsignals 7 ermöglicht ist, wird der Grundzustand so definiert, daß das zweite Schaltelement S2 geschlossen und das erste Schaltelement S1 geöffnet ist, wodurch die Überwachungseinrichtung 2 im Prinzip überbrückt wird.

In der gezeigten Schaltung wird bei Aktivierung des Schaltungsrücksetzsignals RES im Digitalzähler 24 ein Zählerstand von 0000 eingestellt, der als Ausgangszustand des Digitalzählers 24 angesehen werden kann. Weiterhin werden die erste und die zweite Steuerkippstufe 26, 27 sowie die erste Schaltkippstufe 28 rückgesetzt. Die zweite Schaltkippstufe 29 ist gesetzt, und da davon ausgegangen werden kann, daß das Netzausfallsignal 53 inaktiv ist, also einen H-Pegel einnimmt, öffnet die zweite Torschaltung 293 und der zweite Schaltausgang 22, der das zweite Schaltelement S2 zum Schließen bringt, wird aktiviert.

Ab dem Zeitpunkt, zu dem das Schaltungsrücksetzsignal RES inaktiv wird, nimmt die Schaltung nun ihre Funktion auf.

Zu Beginn eines jeweiligen, dem Differenzwerteingang 23 zugeführten Phasendifferenzimpulses wird durch dessen positive Impulsflanke die erste Steuerkippstufe 26 gesetzt, die den Digitalzähler 24 freigibt. Da an den Richtungskontrolleingang UP/DN der dem Phasendifferenzimpuls zugehörige H-Pegel anliegt, erhöht der Digitalzähler 24 im Takt des Taktgebers 25 seinen Zählerstand. Während der Einschwingphase ist ein jeweiliger Phasendifferenzimpuls so lange, daß der Digitalzähler 24 seinen maximalen Zählerstand überschreitet, bevor der begonnene Phasendifferenzimpuls endet. Beim Überschreiten seines maximalen Zählerstandes, der dem Zählerstand von 1111 entspricht, aktiviert der Digitalzähler 24 an seinem Ausgang TC das Überlaufsignal, wodurch die erste Steuerkippstufe 26 und der Digitalzähler 24 wieder rückgesetzt werden.

Sobald ein Phasendifferenzimpuls so kurz ist, daß seine negative Impulsflanke vor Überschreiten des maximalen Zählerstandes auftritt, wird nachdem die erste Steuerkippstufe 26 bei der positiven Impulsflanke getaktet wurde, nun auch die zweite Steuerkippstufe 27 und die erste Schaltkippstufe 28 getaktet. Zugleich mit der negativen Flanke des betreffenden Phasendifferenzimpulses kehrt sich die Zählrichtung des Digitalzählers 24 um, der nun seinen erreichten Zählerstand im Takt des Taktgebers 25 wieder verringert. Beim Unterschreiten seines Ausgangszustandes, dem Zählerstand von 0000, wird am Ausgang TC ein Zählerunterlauf signalisiert, demzufolge die erste Steuerkippstufe 26 und die erste Schaltkippstufe 28 zurückgesetzt werden.

Die zweite Steuerkippstufe 27 bleibt solange gesetzt, bis während eines Phasendifferenzimpulses ein Zählerüberlauf erfolgt, der dann wiederum die erste Steuerkippstufe 26 zurücksetzt, weshalb die zweite Steuerkippstufe 27 mit der negativen Impulsflanke des betreffenden Phasendifferenzimpulses taktet und ihren Rücksetzzustand einnimmt.

Unter der Voraussetzung, daß über eine gewisse Zeitdauer hinweg kein Zählerüberlauf signalisiert wurde, kann der am Ausgang der zweiten Steuerkippstufe 27 anliegende H-Pegel über das Rücksetzverzögerungsglied DR an den Rücksetzeingang R der zweiten Schaltkippstufe 29 dringen und diese zurücksetzen, womit der Einschwingzustand beendet wird und ein Prüfzustand beginnt. Die zurückgesetzte zweite Schaltkippstufe 29 deaktiviert den zweiten Schaltausgang 22 und schafft die Voraussetzungen für eine Aktivierung des ersten Schaltausgangs 21, der in Abhängigkeit von der ersten Schaltkippstufe 28 bei nicht erfolgter Signalisierung eines Zählerüberlaufs am Ende eines jeweiligen Phasendifferenzimpulses von dessen negativer Flanke getaktet wird und bis zur zugehörigen Signalisierung eines Zählerunterlaufes gesetzt ist.

Treten während des Prüfzustandes Phasendifferenzimpulse auf, bei denen Zählerüberläufe signalisiert werden, kann die erste Schaltkippstufe 28 nicht getaktet werden, und es erfolgt keine Aktivierung des ersten Schaltausgangs 21.

Werden über eine gewisse Zeit hinweg nur Phasendifferenzimpulse ausgewertet, die einen Zählerüberlauf auslösen, kann der am negierten Ausgang der zweiten Steuerkippstufe 27 anliegende H-Pegel über das UND-Glied 291 durch das Setzverzögerungsglied DS dringen und die zweite Schaltkippstufe 29 setzen, womit der Prüfzustand beendet und der Einschwingzustand wieder eingestellt ist.

Im Falle eines Netzausfalls, der durch einen L-Pegel am Netzausfallsignal 53 signalisiert wird, werden die erste und die zweite Torschaltung 294, 293 sofort gesperrt und die entsprechenden Schaltausgänge 21, 22 deshalb inaktiv.

Bei Beendigung des Netzausfalls nimmt das Netzausfallsignal 53 wieder einen H-Pegel ein, wobei der dabei auftretende positive Pegelwechsel die zweite Schaltkippstufe 29 taktet und sofort den Einschwingzustand einstellt. Dazu wird davon ausgegangen, daß die zweite Steuerkippstufe 27 nach einem Zählerüberlauf getaktet wurde und an ihrem Ausgang ein L-Pegel anliegt.

Netzausfall, Einschwingzustand und Prüfzustand bilden somit die wesentlichen Zustände der gezeigten Schaltung, wobei bis auf den Übergang vom Netzausfall zum Prüfzustand alle Zustandsübergänge möglich sind. Durch das Setz- und Rücksetzverzögerungsglied DS, RS wird der Übergang vom Prüfzustand zum Einschwingzustand bzw. der Übergang vom Einschwingzustand zum Prüfzustand jeweils einer zeitlichen Bedingung unterworfen, die zum einen ein Mindestmaß an Regelsicherheit garantiert und zum andern eventuelle Störfälle ausschließen soll.

## Ansprüche

1. Schaltungsanordnung zur Bildung eines digitalen Taktsignals, das in Frequenz und Phase mit einer elektrischen Eingangswechselgröße bei deren Anwesenheit übereinstimmt und während deren Abwesenheit weiterhin zur Verfügung steht, unter Verwendung einer Phasenregelschleife mit einem in Abhängigkeit einer Abstimmgröße seine Frequenz verändernden Taktgenerator zur Erzeugung des digitalen Taktsignals, einem Phasenkomparator zur Ermittlung jeweiliger Differenzwerte zwischen der elektrischen Eingangswechselgröße und dem digitalen Taktsignal und mit einem Speicherelement für die von den Differenzwerten korrigierbare Abstimmgröße gekennzeichnet durch eine die jeweiligen Differenzwerte auf Über- bzw. Unterschreitung vorgegebener Grenzwerte prüfende Überwachungseinrichtung (2), die in einem Prüfzustand ausgangsseitig so gesteuert ist, daß nur die innerhalb der Grenzwerte liegenden Differenzwerte an das Speicherelement (3) weitergeleitet und die außerhalb der Grenzwerte liegenden Differenzwerte vollständig unterdrückt werden.

2. Schaltungsanordnung nach Anspruch 1, dadurch gekennzeichnet, daß die Überwachungseinrichtung (2) in einem Einschwingzustand ausgangsseitig so gesteuert ist, daß die jeweiligen vom Phasenkomparator (1) ermittelten Differenzwerte unter Außerachtlassung eines Prüfergebnisses an das Speicherelement (3) weitergeleitet werden und daß die Überwachungseinrichtung (2) eine Regelsicherungseinrichtung aufweist, die eine Umschaltung zwischen Prüf- und Einschwingzustand in der Weise steuert, daß nach einer ununterbrochenen Folge von außerhalb der Grenzwerte liegenden Differenzwerten eine Umschaltung in den Einschwingzustand und nach einer ununterbrochenen Folge von innerhalb der Grenzwerte liegenden Differenzwerten eine Umschaltung in den Prüfzustand erfolgt.

3. Schaltungsanordnung nach Anspruch 2, dadurch gekennzeichnet, daß die Regelsicherungseinrichtung beim Einschalten der Schaltungsanordnung und nach einem Ausfall der elektrischen Eingangswechselgröße (51) bei deren Wiederkehr in den Einschwingzustand schaltet.

4. Schaltungsanordnung nach einem der vorhergehenden Ansprüche, dadurch gekennzeichnet, daß für Differenzwerte, die als Dauer jeweiliger Impulse vorliegen, die Überwachungseinrichtung (2) einen mit einem Taktgeber (25) verbundenen, für die Dauer eines jeden Impulses seine Zählrichtung umkehrenden Digitalzähler (24) aufweist, der mit einer Steuerung derart gekoppelt ist, daß er jeweils mit Beginn eines Impulses zum Verlassen seines Ausgangszustandes freigegeben wird, und daß nur bei Nichterreichen eines als Grenzwert vorgesehenen Zählerstandes des Digitalzählers (24) die Steuerung am Ende des Impulses bis zum Erreichen des Ausgangszustandes ein das Speicherelement (3) mit einem Spannungspotential verbindendes Schaltmittel aktiviert.

5. Schaltungsanordnung nach Anspruch 4, dadurch gekennzeichnet, daß für einen Digitalzähler (24), der bei einem unmittelbaren Zählerstandsübergang von seinem binärwertig kleinsten Zählerstand zu seinem binärwertig größten Zählerstand ein Unterlaufsignal und bei einem unmittelbaren Zählerstandsübergang vom binärwertig größten Zählerstand zum binärwertig kleinsten Zählerstand ein Überlaufsignal aktiviert, und bei den das Überlaufsignal mit dem Unterlaufsignal über eine ODER-Verknüpfung an einem Zählerausgang (TC) zur Verfügung steht, die Steuerung aus einer, mit einer Vorderflanke eines jeweiligen Impulses getakteten ersten Steuerkippstufe (26) und einer nachgeschalteten, mit einer Rückflanke des Impulses taktbaren ersten Schaltkippstufe (28) besteht, daß die erste Steuerkippstufe (26) ausgangsseitig mit einem Freigabe eingang (CE) des Digitalzählers (24) verbunden ist, daß der Zählerausgang (TC) über einen Rücksetzsignalpfad an jeweils einen asynchronen, zum Einstellen eines Ausgangszustandes vorgesehenen Eingang (R) der ersten Steuerkippstufe (26), der ersten Schaltkippstufe (28) sowie des Digitalzählers (24) angeschlossen ist, und daß die erste Schaltkippstufe (28) ausgangsseitig über eine erste Torschaltung (294) an einen Aktivierungseingang eines das Speicherelement (3) mit einem Spannungspotential verbindenden ersten Schaltelementes (S1) angeschlossen ist.

6. Schaltungsanordnung nach Anspruch 5, **dadurch gekennzeichnet,** daß die Regelsicherungseinrichtung aus einer, der ersten Steuerkippstufe (26) nachgeschalteten und mit einer Rückflanke eines jeweiligen Impulses taktbaren zweiten Steuerkippstufe (27) besteht, die ausgangsseitig zum Einstellen des Prüf- oder Einschwingzustandes über jeweils einen Signalverzögerungspfad mit den beiden asynchronen Eingängen (S,R) einer zweiten Schaltkippstufe (29) verbunden ist, und daß die zweite Schaltkippstufe (29) ausgangsseitig an einer ersten Sperreingang der ersten Torschaltung (294) und über eine zweite Torschaltung (293) an einen Aktivierungseingang eines das Speicherelement (3) mit einem Analogwertausgang (13) des Phasenkomparators (1) verbindenden zweiten Schaltelementes (S2) angeschlossen ist.

7. Schaltungsanordnung nach Anspruch 6, **dadurch gekennzeichnet,** daß die zweite Schaltkippstufe (29) an ihrem D-Eingang mit einem konstanten logischen Pegel beaufschlagt ist, daß die zweite Schaltkippstufe (29) an ihrem Takteingang mit einem, einen Ausfall der elektrischen Eingangswechselgröße (51) signalisierenden Netzausfallsignal (53) beaufschlagt ist, daß der zum Einschalten des Einschwingzustandes vorgesehene Signalverzögerungspfad aus einer Hintereinanderschaltung eines das Netzausfallsignal (53) logisch verknüpfenden UND-Gliedes (291), eines Setzverzögerungsgliedes (DS) und eines das Schaltungsrücksetzsignal (RES) logisch verknüpfenden zweiten ODER-Gliedes (292) besteht, daß der zum Einschalten des Prüfzustandes vorgesehene Signalverzögerungspfad ein Rücksetzverzögerungsglied (DR) aufweist, und daß ein zweiter Sperreingang der ersten Torschaltung (294) sowie ein Sperreingang der zweiten Torschaltung (293) mit dem Netzausfallsignal (53) beaufschlagt sind.

8. Schaltungsanordnung nach einem der Ansprüche 5 bis 7, **dadurch gekennzeichnet,** daß das erste Schaltelement (S1) in Abhängigkeit des zuletzt am Analogwertausgang (13) des Phasenkomparators (1) vorgegebenen digitalen Pegels mit einem von zwei unterschiedlichen Spannungspotentialen beaufschlagbar ist.

# FIG 1

# FIG 2